# EUROPEAN PATENT APPLICATION

(11) **EP 4 727 009 A1**
(43) Date of publication of application: **15.04.2026**
(21) Application number: 25208392.8
(22) Date of filing: 13.10.2025
(51) Int. Cl.: H02S 40/34, H10F 19/70, H10F 19/90, H10F 77/00

(54) **PHOTOVOLTAIC MODULE**

(30) Priority: 14.10.2024 CN 202411434648
(71) Applicant: JINKO SOLAR CO., LTD, ShangRao, Jiangxi 334100 (CN); Zhejiang Jinko Solar Co., Ltd., Haining, Zhejiang 314416 (CN)
(72) Inventor: TAO, Wusong, SHANGRAO 334100 (CN); WANG, Luchuang, SHANGRAO 334100 (CN); HAN, Xiangchao, SHANGRAO 334100 (CN); ZHU, Lei, SHANGRAO 334100 (CN)
(74) Representative: DREISS Patentanwälte PartG mbB

(57) **Abstract**

Provided is a photovoltaic module including cell strings. Each of the cell strings includes multi segmented cells connected in series. Two ends of one of the cell strings are provided with a busbar to connect the multi segmented cells, the busbar includes a first busbar, a second busbar and a third busbar. Along a first direction, the first busbar, the second busbar and the third busbar are spaced apart. An end of the first busbar opposite to the second busbar is a first lead-out end, and an end of the second busbar opposite to the third busbar is a second lead-out end. The photovoltaic module further includes a first jumper wire, the first jumper wire overlaps with the second busbar. A first bending portion is provided on an end of the first busbar adjacent to the second busbar. A side of the first jumper wire away from the second busbar is provided with a first lead out member. This facilitates adjusting a distance between the first lead out member and the first bending portion, thereby reducing the possibility short circuit caused by accidental contact between the first lead out member and the first bending portion, and improving the safety of the photovoltaic module.

## Description

### TECHNICAL FIELD

The present disclosure relates to the field of photovoltaic power technology, and in particular, to a photovoltaic module.

### BACKGROUND

In photovoltaic modules, the photovoltaic effect of the cells converts light energy into electrical energy. The electrical energy generated by the cells is collected and exported through the busbars by connecting multiple cells in series. In related art, the cells within a cell string are in a two-segmented configuration. As the size of the cells increases, the current within a single cell string becomes larger, resulting in significant power loss of the photovoltaic module.

### SUMMARY

The present disclosure provides a photovoltaic module to solve the technical problem of high overall power loss in photovoltaic modules.

In some embodiments, the present disclosure provides a photovoltaic module. The photovoltaic module includes:
cell strings, in which each of the cell strings includes multi segmented cells connected in series; two ends of one of the cell strings are provided with a busbar to connect the multi segmented cells, the busbar includes a first busbar, a second busbar and a third busbar, along a first direction, the first busbar, the second busbar and the third busbar are spaced apart, an end of the first busbar opposite to the second busbar is a first lead-out end, and an end of the second busbar opposite to the third busbar is a second lead-out end;
a jumper wire that is connected to the busbar and extends along a second direction perpendicular to the first direction; in which the jumper wire includes a first jumper wire, the first jumper wire overlaps with the second busbar, and a first lead out member is provided on a side of the jumper wire away from the second busbar, and a first bending portion is provided on an end of the first busbar adjacent to the second busbar, the first lead out member and the first bending portion both extend along a thickness direction of the photovoltaic module, to form the first lead-out end.

In some embodiments of the present disclosure, the first lead out member includes a first fixing portion and a first lead out portion, an angle is formed between the first fixing portion and the first lead out portion, the first fixing portion is connected to the first jumper wire, and the first lead out portion extends along the thickness direction of the photovoltaic module.

In some embodiments of the present disclosure, a width of the first fixing portion is greater than or equal to a width of the first jumper wire.

In some embodiments of the present disclosure, the jumper wire further includes a second jumper wire located between the second busbar and the third busbar.

In some embodiments of the present disclosure, a second bending portion is provided on one end of the second busbar adjacent to the second jumper wire, a third bending portion is provided on one end of the third busbar adjacent to the second jumper wire, and the second jumper wire includes a fourth bending portion, in which the second bending portion, the third bending portion, and the fourth bending portion are all bent along the thickness direction of the photovoltaic module, to form the second lead-out end.

In some embodiments of the present disclosure, the second jumper wire further includes a first straight segment and a second straight segment, the first straight segment and the second straight segment both extend along the length direction of the photovoltaic module, and the fourth bending portion is located between the first straight segment and the second straight segment ; in which the fourth bending portion includes a first bending segment and a second bending segment, the first bending segment and the second bending segment both extend along the thickness direction of the photovoltaic module, and are connected to each other through one end of the first bending segment and one end of the second bending segment, another end of the first bending segment is connected to the first straight segment, and another end of the second bending segment is connected to the second straight segment.

In some embodiments of the present disclosure, along the thickness direction of the photovoltaic module, the jumper wire is located on one side of the multi segmented cell ; and along the width direction of the jumper wire, the spacing between two adjacent segmented cells is smaller than the width of the jumper wire, the photovoltaic module includes an isolation member, along the thickness direction of the photovoltaic module, the isolation member is provided between the jumper wire and the multi segmented cell.

In some embodiments of the present disclosure, a width of the jumper wire ranges from 4 mm to 8 mm; and a thickness of the jumper wire ranges from 0.15 mm to 0.4 mm.

In some embodiments of the present disclosure, a width of the isolation member ranges from 8 mm to 18 mm, and a thickness of the isolation member ranges from 0.15 mm to 0.25 mm.

In some embodiments of the present disclosure, the photovoltaic module further includes a first lead-out hole and a second lead-out hole, in which the first lead-out end is led out from the first lead-out hole, the second lead-out end is led out from the second lead-out hole, and a cross-sectional area of the first lead-out hole is smaller than or equal to a cross-sectional area of the second lead-out hole.

The present disclosure relates to a photovoltaic module, which includes cell strings. Each of the cell strings includes multi segmented cells connected in series. Two ends of one of the cell strings are provided with a busbar to connect multiple cell strings. The busbar includes a first busbar, a second busbar and a third busbar. Along a first direction, the first busbar, the second busbar and the third busbar are spaced apart. An end of the first busbar opposite to the second busbar is a first lead-out end, and an end of the second busbar opposite to the third busbar is a second lead-out end. The photovoltaic module further includes a first jumper wire, the first jumper wire overlaps with the second busbar. A first bending portion is provided on an end of the first busbar adjacent to the second busbar. A side of the first jumper wire away from the second busbar is provided with a first lead out member. This facilitates adjusting a distance between the first lead out member and the first bending portion, thereby reducing the possibility short circuit caused by accidental contact between the first lead out member and the first bending portion, and improving the safety of the photovoltaic module.

It should be understood that the general description provided above and the detailed description in the following text are merely illustrative and do not limit the present disclosure.

### BRIEF DESCRIPTION OF DRAWINGS

FIG. 1 is a schematic diagram of a circuit of a photovoltaic module provided by some embodiments of the present disclosure;
FIG. 2 is a structural schematic diagram of a photovoltaic module provided by some embodiments of the present disclosure;
FIG. 3 is a positional relationship diagram of the multi segmented cells, isolation members, and jumpers provided by some embodiments of the present disclosure;
FIG. 4 is a partial enlarged view of position I in FIG. 2;
FIG. 5 is a schematic diagram of an embodiment of a first lead-out end provided by some embodiments of the present disclosure;
FIG. 6 is a schematic diagram of another embodiment of the first lead-out end provided by some embodiments of the present disclosure;
FIG. 7 is a top view of the first lead-out end provided by some embodiments of the present disclosure;
FIG. 8 is a partial enlarged view of position II in FIG. 2;
FIG. 9 is a side view of a second lead-out end provided by some embodiments of the present disclosure;
FIG. 10 is a top view of a second lead-out end provided by some embodiments of the present disclosure;
FIG. 11 is a structural schematic diagram of an embodiment of a second jumper wire provided by some embodiments of the present disclosure;
FIG. 12 is a schematic structural diagram of another embodiment of a second jumper wire provided by some embodiments of the present disclosure;
FIG. 13 is a schematic structural diagram of another embodiment of a second jumper wire provided by some embodiments of the present disclosure.

Reference signs:
1- Cell string;
11- Multi segmented cell;
2- Busbar
21- First busbar;
211 - First bending portion;
22- Second busbar
221- Second bending portion;
222- Fifth bending portion;
23- Third busbar;
231- Third bending portion;
24- Edge busbar;
3- Jumper wire
31- First jumper wire;
32- Second jumper wire;
321- Fourth bending portion;
321a - First bending segment;
321b - Second bending segment;
322- First straight segment;
323- Second straight segment;
324- First body portion;
325- Second body portion;
325a - Third straight segment;
325b - Third bending segment;
4- First lead out member;
41- First fixing portion;
42- First lead out portion;
5- Isolation member
6- First lead out hole;
7- Second lead out hole;
8- Second lead out member;
81- Second fixing portion; and
82- Second lead out portion.

The attached drawings herein are incorporated into the specification and form part of it, which illustrate the embodiments of the present disclosure and are used together with the specification to explain the principles of the present disclosure.

### DESCRIPTION OF EMBODIMENTS

In order to better understand technical solutions of the present disclosure, the embodiments of the present disclosure are described in details with reference to the drawings.

It should be clear that the described embodiments are merely part of the embodiments of the present disclosure rather than all of the embodiments. All other embodiments obtained by those skilled in the art without paying creative labor shall fall into the protection scope of the present disclosure.

The terms used in the embodiments of the present disclosure are merely for the purpose of describing specific embodiment, rather than limiting the present disclosure. The terms "a", "an", "the" and "said" in a singular form in the embodiment of the present disclosure and the attached claims are also intended to include plural forms thereof, unless noted otherwise.

It should be understood that the term "and/or" used in the context of the present disclosure is to describe a correlation relation of related objects, indicating that there may be three relations, e.g., A and/or B may indicate only A, both A and B, and only B. In addition, the symbol "/" in the context generally indicates that the relation between the objects in front and at the back of "/" is an "or" relationship.

It should be noted that the directional terms such as "up", "down", "left", "right", etc. described in the present disclosure are used based on the angle shown in the attached drawing and should not be construed as a limitation of the present disclosure. Additionally, in the context, it is also necessary to understand that when it is mentioned that one component is "connected on" or "connected below" another component, it can not only be directly connected on or below the other component, but also be indirectly connected on or below the other component through an intermediate component.

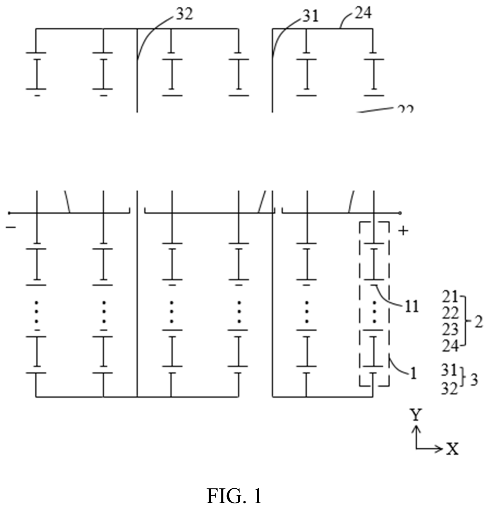

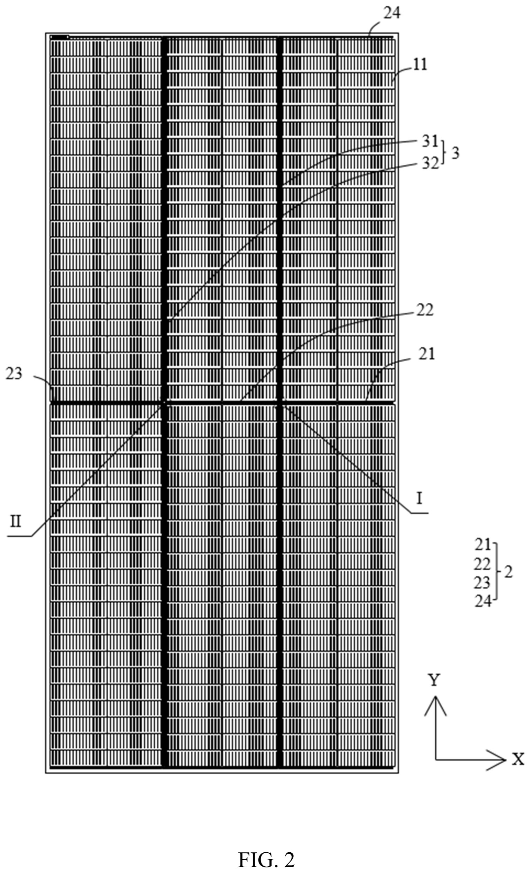

As shown in FIG. 1 and FIG. 2, the present disclosure provides a photovoltaic module. The photovoltaic module includes multiple cell strings 1. At both ends of the cell strings 1, busbars 2 are provided to connect multiple cell strings 1. Along the thickness direction Z of the photovoltaic module, the front side of the cell strings 1 is provided with photovoltaic glass, and an adhesive film layer is provided between the photovoltaic glass and the cell string 1. The back side of the cell string 1 is provided with a back plate or photovoltaic glass. Between the cell strings 1 and the back plate or photovoltaic glass, there is also an adhesive film layer. After lamination, a laminated member is formed. A frame is provided along the periphery of the laminated member to protect the edge of the laminated piece and form the photovoltaic module.

The cell string 1 includes multiple multi segmented cells 11 connected in series. The types of multi segmented cell 11 in the embodiments of the present disclosure include, but are not limited to Passivated Emitting electrode Rear Cell (PERC), Tunnel Oxide Passivated Contact (TOPCon), Heterojunction with Intrinsic Thin film (HJT), Interdigitated Back Contact (IBC), Perovskite Solar Cells (PSC), Multi-gate Cells (MBB) and Zero-gate Cells (0BB)etc.

For the PERC cells, along their thickness direction, PERC cells successively include a front surface metal silver electrode, a front surface silicon nitride passivation layer, a phosphorus layer emitter, a P-type base silicon layer, a local aluminum back field, a metal aluminum back electrode, and a back passivation layer (Al₂O₃/SiNx). PERC cells adopt a passivation film to passivate the back, replacing the full aluminum back field, enhancing the internal back reflection of light on the silicon substrate, reducing the recombination rate on the back, and increasing the cell efficiency by 0.5% - 1%.

For the TOPCon cell, along their thickness direction, the TOPCon cell sequentially includes a metal silver electrode, a front surface silicon nitride passivation layer, a boron doped emitting electrode, an N-type base silicon layer, a diffusion doped layer, ultra-thin silicon oxide, doped polycrystalline silicon, silicon nitride, and a metal silver electrode. The back of the cell is composed of an ultra-thin silicon oxide layer (1nm~2nm) and a layer of phosphorus doped microcrystalline amorphous mixed Si film, which together form a passive contact structure. This structure can block the recombination of minority carrier holes, and improve the open circuit voltage and short-circuit current of the cell. The ultra-thin oxide layer can enable majority carrier electrons to tunnel into the polycrystalline silicon layer while blocking the recombination of minority carrier holes. The excellent passivation effect of ultra-thin silicon oxide and heavily doped silicon film causes the surface energy bands of silicon wafers to bend, thereby forming a field passivation effect. The probability of electron tunneling increases significantly, the contact resistance decreases, and the open circuit voltage and short-circuit current of the cell are improved, thereby enhancing the conversion efficiency of the cell.

For the HJT cell, along its thickness direction, the HJT cell sequentially includes a front low-temperature silver electrode, a front conductive film, an N-type amorphous silicon film, an intrinsic amorphous silicon film, an N-type base silicon layer, an intrinsic amorphous silicon film, a P-type amorphous silicon film, a back conductive film, and a back low-temperature silver electrode.

For IBC cells, along the thickness direction, IBC cells successively include a silicon nitride anti-layer, an N+ front surface field, a N-type base silicon layer, a P+ emitter, an N+ back field, an aluminum oxide passivation layer, a silicon nitride anti-reflection layer, and a metal silver electrode. IBC cells can obtain uniformity and precisely controllable P and N regions with good quality through ion implantation technology. The front surface of the cell is not blocked by the grid lines, which can eliminate the loss of shading current due to the shielding effect of the metal electrode, achieving the maximum utilization of incident photons. Compared with conventional solar cells, the short-circuit current of IBC cells can be increased by about 7%. Due to the back-contact structure, there is no need to consider the problem of grid line shading, and the grid line ratio can be appropriately widened, thereby reducing the series resistance and achieving a high fill factor. The surface passivation and surface light trapping structures can be optimally designed, resulting in a lower front surface recombination rate and surface reflection.

For the perovskite cell, along its thickness direction, the perovskite cell sequentially includes a substrate material, a conductive thin film, an electron transport layer (titanium dioxide), a perovskite absorption layer (hole transport layer), and a metal cathode. The perovskite material has high light absorption coefficient and long carrier diffusion distance. The photons absorbed by the perovskite material are converted into electrons, which are easily collected by the electrode with small loss. Therefore, it can generate high photovoltaic voltage and current, making perovskite exhibit high photoelectric conversion efficiency.

For the multi-busbar cell, multiple busbars for collecting current are provided on the surface of cell, which shortens the conduction path of current in the multi-busbar cell, reduces internal losses, and thus improves the power of the multi-busbar cell. As the number of busbars increases, the cross-sectional area of the busbars and the electrode line decreases, and the adhesive film layer becomes thinner, which can reduce the production cost of the photovoltaic module. With the increase of the number of the busbar, the number of fingers can be correspondingly reduced, which can reduce the production cost of the cell.

For the zero busbar cell, there is no busbar on the surface of cell. After multiple cells are soldered, the electrode line replaces the original busbar to directly connect to the finger, which can reduce the consumption of silver paste and lower the production cost of cell. The zero busbar cell can reduce the shading area of the grid line in the cell, reduce the transmission loss of the finger, and improve the total power of the assembly. Meanwhile, the increase in finger contacts reduces the risk of hidden cracks in thin silicon wafers, improving yield and reliability.

The multiple multi segmented cells 11 in the cell string 1 can be soldered by the stitch soldering technology. The adjacent two multi segmented cells 11 overlap each other, and the overlapping area has a size of 0.2 mm to 0.6 mm. Then, an electrode line is provided in the overlapping area of the adjacent two multi segmented cells 11 to connect the adjacent two multi segmented cells 11 and form the cell string 1. The multiple multi segmented cells 11 in the cell string 1 are connected in series by the stitch soldering method, which can reduce the spacing between multiple multi segmented cells 11 in the cell string 11, increase the area proportion of the multi segmented cells 11 in the photovoltaic module, thereby increasing the effective light absorption area in the photovoltaic module, and can increase the power output of the photovoltaic module. The adjacent two multi segmented cells 11 are arranged in an overlapping manner, and an electrode line is provided in the overlapping area. In the laminating process, the overlapping area is prone to stress concentration problems. In the overlapping area of the adjacent two multi segmented cells 11, a buffer layer can also be provided to reduce the possibility of hidden cracks of the multi segmented cell 11.

The multi segmented cell 11 can be segmented into two-segmented cell, three-segmented cell, four-segmented cell, etc. Taking the four-segmented cell as an example, the complete cell is divided into four equal parts to form four-segmented cell. According to the different sizes of the complete cell, the length of the four-segmented cell can be 182.3mm, and the width can be 46.675mm to 53.25mm. After the multiple four-segmented cells in the cell string 1 are stitched, the overlapping area width between adjacent four-segmented cells can be 0.2mm to 0.6mm, and the spacing between adjacent cell strings 1 can be 1.2 mm to 1.6 mm, so that the length of the photovoltaic module can be 2278 mm to 2382 mm, and the width can be 1134 mm. The current of the four-segmented cell is 1/4 of the current of the bent cell, so the current of the single cell string 1 is also 1/4 of the current of the complete cell, which can reduce the power loss of the single cell string 1 and achieve the power increase of the photovoltaic module. The photovoltaic module includes multiple cell strings 1 connected in series by the four-segmented cells, and the four cell strings 1 are connected in parallel by the busbar 2, and then multiple cell string groups are connected in series to make the output current of the photovoltaic module the same as the output current of the cell string 1 connected in series by the bent cell.

As shown in FIG. 1 and FIG. 2, the busbar 2 includes the first busbar 21, the second busbar 22 and the third busbar 23, which are used to connect multiple cell strings 1. Along the first direction X, the first busbar 21, the second busbar 22 and the third busbar 23 are spaced apart, and an end of the first busbar 21 opposite to the second busbar 22 is a first lead-out end, and a first junction box is provided at the first lead-out end, the first busbar 21 and the second busbar 22 are connected to the first junction box. An end of the second busbar 22 opposite to the third busbar 23 is a second lead-out end, and a second junction box is provided at the second lead-out end, the second busbar 22 and the third busbar 23 are connected to the second junction box, the first junction box and the second junction box are connected to the external equipment.

As shown in FIG. 1, FIG. 2 and FIG. 3, the photovoltaic module also includes jumper wire 3, the jumper wire 3 is connected to the busbar 2 and extends along the second direction Y, the second direction Y is perpendicular to the first direction X, so that the jumper wire 3 can connect multiple busbars 2. In some embodiments of the present disclosure, along the width direction X of the jumper wire 3, the spacing between adjacent multi segmented cells 11 is smaller than the width of the jumper wire 3, along the thickness direction Z of the photovoltaic module, the jumper wire 3 is located on one side of the multi segmented cells 11. Along the thickness direction Z of the photovoltaic module, a separation member 5 is provided between the jumper wire 3 and the multi segmented cell 11 to separate the multi segmented cell 11 from the jumper wire 3.

The isolation member 5 is made of an insulating material. The jumper wire 3 is a conductive metal strip. By placing the isolation member 5 between the jumper wire 3 and the multi-segmented cell 11, the possibility of short circuit caused by the contact between the jumper wire 3 and the cell can be reduced, thereby enhancing the safety of the photovoltaic module.

In some embodiments of the present disclosure, the width of the jumper wire 3 ranges from 4 mm to 8 mm, and the thickness of the jumper wire 3 ranges from 0.15 mm to 0.4 mm.

If the width of the jumper wire 3 is smaller than 4 mm, and the thickness of the jumper wire 3 is smaller than 0.15 mm, the cross-sectional area of the jumper wire 3 will be smaller, resulting in poor overcurrent capacity of the jumper wire 3, which cannot bear the current in the photovoltaic module. If the width of the jumper wire 3 is greater than 8mm, the size of the overlapping area between the jumper wire 3 and the multi segmented cells 11 increases. During the lamination process, the jumper wire 3 increase the risk of hidden cracks in the multi segmented cell 11. If the photovoltaic module is a double glass module, both sides of the multi segmented cells 11 are used to absorb sunlight, and the width of the jumper wire 3 is too large, it will increase the shielding of the multi segmented cells 11, thereby affecting the power generation efficiency. Therefore, the width of the jumper wire 3 can be 4 mm, 6 mm, 8 mm, etc. Along the width direction X of the jumper wire 3, the spacing between adjacent multi segmented cells 12 is 1.6 mm, which is smaller than the width of the jumper wire 3. Therefore, the jumper wire 3 is provided on one side of the thickness direction Z of the multi segmented cells 11. If the thickness of the jumper wire 3 is greater than 0.4 mm, causing the jumper wire 3 to protrude from the multi segmented cells 11 by a larger size, during the lamination process, it will increase the possibility of the jumper wire 3 squeezing the multi segmented cells 11 and causing hidden cracks in the multi segmented cells 11. It will also increase the possibility of deformation of the jumper wire 3, resulting in short circuit caused by contact between the jumper wire 3 and the multi segmented cells 11. Therefore, the thickness of the jumper wire 3 can be 0.15 mm, 0.3 mm, 0.4 mm, etc.

In some embodiments of the present disclosure, the width L6 of the isolation member 5 ranges from 8 mm to 18 mm, and the thickness L8 of the isolation member 5 ranges from 0.15 mm to 0.25 mm.

The isolation member 5 is used to separate the jumper wire 3 from the multi segmented cell 11. The jumper wire 3 is centrally placed on the isolation member 5, to reduce the possibility of short circuit caused by their contact. Therefore, the width of the isolation member 5 needs to be greater than the width of the jumper wire 3. If the width L6 of the isolation member 5 is smaller than 8 mm, it will increase the possibility of short circuit caused by the contact between the jumper wire 3 and the multi segmented cell 11. If the width of the isolation member 5 is greater than 18 mm, the area of the overlapping region between the isolation member 5 and the multi segmented cell 11 will also increase, resulting in an increased impact of the isolation member 5 for the multi segmented cell 11 during the lamination process. In the double glass module, the impact on power generation efficiency is significant. Therefore, the width of the isolation member 5 can be 8 mm, 13 mm, 18 mm, etc. The isolation member 5 are located between the jumper wire 3 and the multi segmented cell 11. If the thickness of the isolation member 5 is greater than 0.25 mm, the thickness of the jumper wire 3 and the isolation member 5 will be too large. During the lamination process, the stress at the positions of the jumper wire 3 will be high, which can easily cause the multi segmented cell 11 to have hiding crack. The isolation member 5 serve as insulation between the jumper wire 3 and the multi segmented cell 11. The insulation performance of the isolation member 5 decreases with decreasing thickness of the isolation member 5. If the thickness of the isolation member 5 is smaller than 0.15 mm, the insulation performance of the isolation member 5 is poor, and there is a high possibility of short circuit between the jumper wire 3 and the multi segmented cell 11. Therefore, the thickness of the isolation member can be 0.15 mm, 0.2 mm, 0.25 mm, etc.

As shown in FIG. 2, FIG. 4 and FIG. 5, in some embodiments of the present disclosure, the jumper wire 3 includes a first jumper wire 31 that overlaps with the second busbar 22. A first lead out member 4 is provided on a side of the first jumper wire 31 away from the second busbar 22. A first bending portion 211 is provided at one end of the first busbar 21 adjacent to the second busbar 22. Both the first lead out member 4 and the first bending portion 211 extend along the thickness direction Z of the photovoltaic module to form the first lead-out end.

In the process of assembling the photovoltaic module, firstly the jumper wire 3 is bonded with the isolation member 5, and then laid on the multi segmented cell 11. At the position where the first jumper wire 31 overlaps with the second busbar 22, a notch is provided on the isolation member 5 to avoid the second busbar 22, so that the distance between the second busbar 22 and an edge of the isolation member 5 is 1mm to 2mm, facilitating the soldering of the first jumper wire 31 and the second busbar 22. In this embodiment, the photovoltaic module can include three cell string groups. Each of cell string groups includes four cell strings 1 arranged in a matrix pattern. Each cell string 1 includes multiple quarter-segmented cells connected in series. Along the second direction Y, edge busbars 24 are provided on both sides of each cell string groups. The first busbar 21 is located in the middle position of the first cell string groups, and the first busbar 21 is connected with the edge busbar 24 to form a first cell string group by four cell strings 1 in parallel. The second busbar 22 is located in the middle position of the second cell string group, and the second busbar 22 is connected with the edge busbar 24 to form the second cell string group by four cell strings 1 in parallel. The third busbar 23 is located in the middle position of the third group of cell string groups, and the third busbar 23 is connected with the edge busbar 24 to form the third cell string group by four cell strings 1 in parallel. Among them, the edge busbar 24 of the second cell string group is connected with the edge busbar 24 of the third cell string group, so that the second cell string group and the third cell string group are connected in series. The two ends of the first jumper wire 31 are respectively connected to the two edge busbars 24 of the first cell string group. The first jumper wire 31 overlaps with the second busbar 22 to connect the third cell string group with the second cell string group in series.

The busbar 2, the jumper wire 3, and the lead out wire are all conductive metal bars. The first lead out member 4 is connected to the first busbar 21 which can lead out the current inside the first busbar 21. A diode is installed in the first junction box. The first lead out member 4 and the first bending portion 211 are respectively connected to the two ends of the diode. In the case of a failure in the second or third cell string group, the diode can allow the current to bypass the faulty cell string group, thereby protecting the circuit. The first lead out member 4 is spaced apart from the first bending portion 211. The first lead out member 4 is provided on a side of the first jumper wire 31 away from the second busbar 22, so that the position of the first lead out member 4 can be adjusted toward a direction away from the first bending portion 211 along the extension direction of the second busbar 22, so that the first lead out member 4 can be in contact with the first jumper wire 31, thereby increasing the gap between the first lead out member 4 and the first bending portion 211, reducing the short circuit possibility due to accidental contact between the first lead out member 4 and the first bending portion 211, and improving the safety of the photovoltaic module.

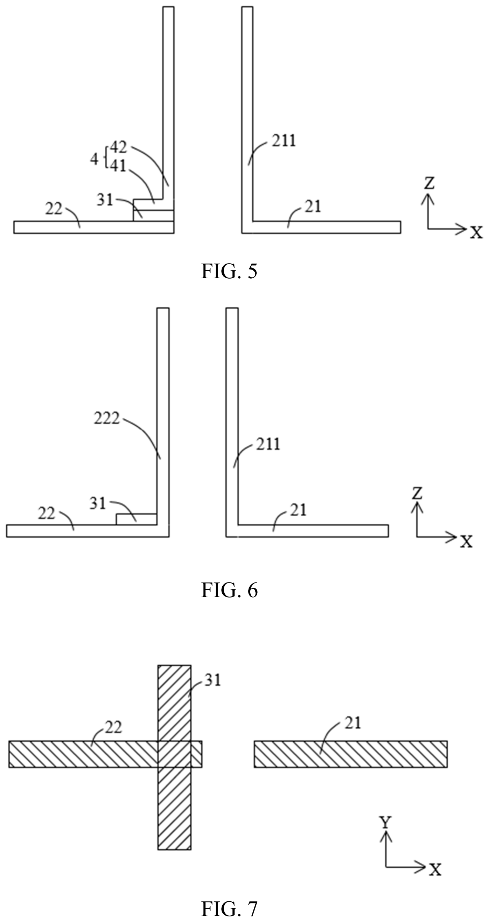

As shown in FIG. 5, in some embodiments of the present disclosure, the first lead out member 4 includes a first fixing portion 41 and a first lead out portion 42. The first fixing portion 41 is connected to the first jumper wire 31, and there is an angle between the first lead out portion 42 and the first fixing portion 41, so that the first lead out portion 42 extends along the thickness direction Z of the photovoltaic module.

The first jumper wire 31 is soldered to the second busbar 22, and the first fixing portion 41 is soldered to the first jumper wire 31. The lead out wire has an angle with the first fixing portion 41, so that the first lead out portion 42 of the first lead out member 4 can be connected to the first junction box and approximately parallel to the first bending portion 211 of the first busbar 21, thereby reducing the possibility of accidental contact between the first lead out portion 42 and the first bending portion 211, and improving the safety of the photovoltaic module.

As shown in FIG. 5, in some embodiments of the present disclosure, the width of the first fixing portion 41 is greater than or equal to the width of the first jumper wire 31.

The first fixing portion 41 is soldered to the first jumper wire 31, and the width of the first fixing portion 41 increases, which can improve the reliability of the first fixing portion 41 and the first jumper wire 31 after soldering. If the end of the first fixing portion 41 protrudes from the first jumper wire 31, and the thickness of the jumper wire 3 is small, the portion of the first fixing portion 41 protruding from the first jumper wire 31 can be bent towards a direction adjacent to the second busbar 22, so that the portion of the first fixing portion 41 protruding from the first jumper wire 31 is soldered to the second busbar 22, which can further improve the reliability of the lead out member after soldering.

As shown in FIG. 6 and FIG. 7, in some embodiments of the present disclosure, a fifth bending portion 222 is provided on a side of the second busbar 22 adjacent to the first busbar 21. The fifth bending portion 222 extends along the thickness direction Z of the photovoltaic module and is parallel to the first bending portion 211.

The first jumper wire 31 is located at the position where the second busbar 22 is provided with the fifth bending portion 222, and is soldered to the second busbar 22, so that the current inside the jumper wire 3 can be led out through the fifth bending portion 222. The second busbar 22 is bent to form the fifth bending portion 222, reducing the number of soldering times at the first lead out position, thereby reducing the risk of open soldering, and improving the reliability of the photovoltaic module.

As shown in FIG. 1 and FIG. 2, in some embodiments of the present disclosure, the jumper wire 3 also includes a second jumper wire 32. The second jumper wire 32 is located between the second busbar 22 and the third busbar 23. The two ends of the second jumper wire 32 are respectively connected to two edge busbars 24 of the second cell string group and two edge busbars 24 of the third cell string group.

Two diodes are provided in the second junction box. The end of the second busbar 22 closer to the third busbar 23 is connected to one end of a diode, one side of the second jumper wire 32 is connected to the other end of one diode, the other side of the second jumper wire 32 is connected to one end of another diode, and the other end of the third busbar 23 is connected to the other end of another diode. When one or more multi segmented cells 11 in the second cell string group 11 or one or more multi segmented cells 11 in the third cell string group fail, the diodes in the second junction box conducts with the second jumper wire 32, bypassing the faulty cell string group and protecting the circuit.

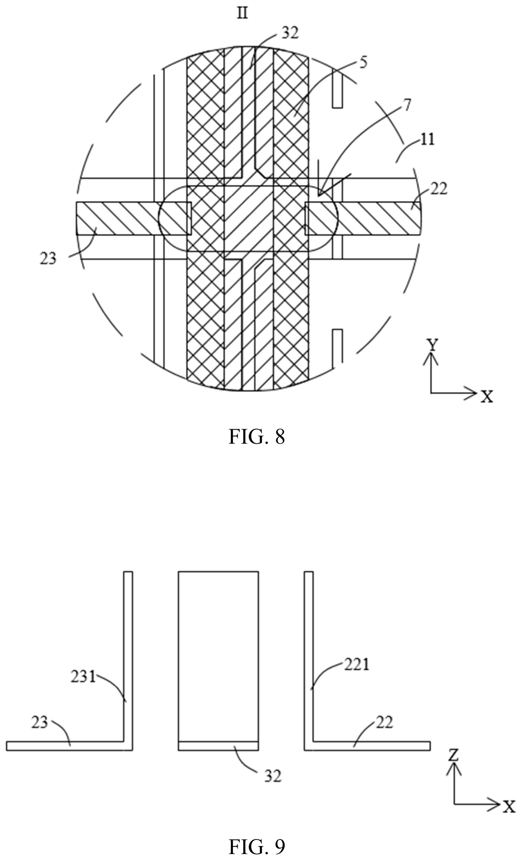

As shown in FIG. 8, FIG. 9, and FIG. 10, in some embodiments of the present disclosure, a second bending portion 221 is provided at one end of the second busbar 22 adjacent to the second jumper wire 32, and a third bending portion 231 is provided at one end of the third busbar 23 adjacent to the second jumper wire 32. The second jumper wire 32 includes a fourth bending portion 321, which is located between the second bending portion 221 and the third bending portion 231. The second bending portion 221, the third bending portion 231, and the fourth bending portion 321 are all bent along the thickness direction Z of the photovoltaic module, forming a second lead-out end. The second jumper wire 32 does not need to be connected to the second busbar 22 or the third busbar 23. Therefore, the isolation member 5 located between the second jumper wire 32 and the multi segmented cell 11 is a continuous insulating strip, and there is no need to set an avoiding structure at the second busbar 22 or the third busbar 23, which facilitates the arrangement of the isolation member 5 and improves the assembling efficiency of the photovoltaic module.

The second bending portion 221, the third bending portion 231, and the fourth bending portion 321 all extend along the thickness direction Z of the photovoltaic module, so that the second lead-out end protrudes from the photovoltaic module, facilitating connection with the second junction box. The second bending portion 221, the third bending portion 231, and the fourth bending portion 321 all extend in the same direction and can have an approximately parallel structure, which can reduce the possibility of short circuit caused by accidental contact of the second bending portion 221, the third bending portion 231, and the fourth bending portion 321.

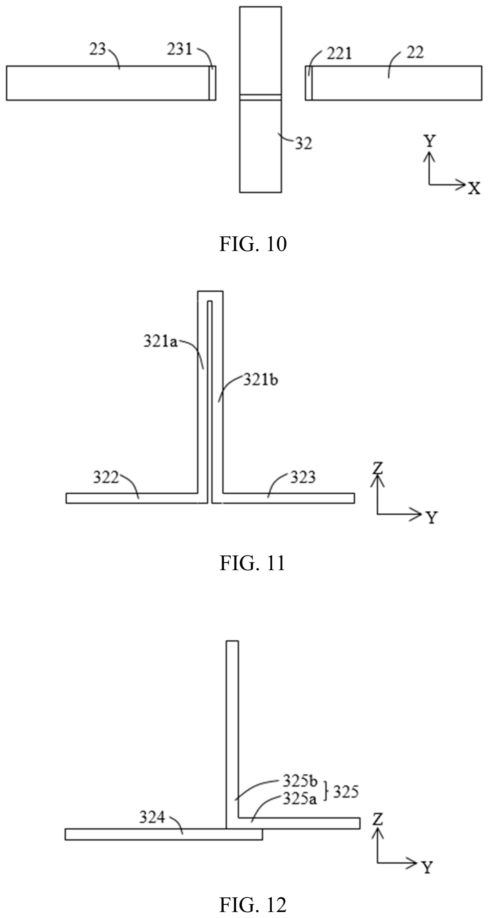

As shown in FIG. 11, in some embodiments of the present disclosure, the second jumper wire 32 includes a first straight segment 322 and a second straight segment 323, and a fourth bending portion 321 located between the first straight segment 322 and the second straight segment 323. Both the first straight segment 322 and the second straight segment 323 extend along the second direction Y. The end of the first straight segment 322 and the second straight segment 323 that are away from the fourth bending portion 321 is connected to the edge busbar 24. The fourth bending segment 221 includes a first bending segment 321a and a second bending segment 321b, both of which extend along the thickness direction Z of the photovoltaic module. One end of the first bending segment 321a is connected to one end of the second bending segment 321b, the other end of the first bending segment 321a is connected to the first straight segment 322, and the other end of the second bending segment 321b is connected to the second straight segment 323, so that the second jumper wire 32 has a C-shaped structure.

There may be a gap or mutual adhesion between the side walls of the first bending segment 321a and the second bending segment 321b in the fourth bending portion 321, so that the fourth bending portion 321 can extend along the thickness direction Z of the photovoltaic module. The first straight segment 322, the second straight segment 323, and the fourth bending portion 321 are bent and formed by the second jumper wire 32, reducing the peeling off possibility of the fourth bending portion 321, and improving the reliability after the connection between the second lead-out end and the second junction box.

As shown in FIG. 12, in some embodiments of the present disclosure, the second jumper wire 32 includes a first body portion 324 and a second body portion 325. The first body portion 324 extends along the second direction Y, and the second body portion 325 includes a third straight segment 325a and a third bending segment 325b. The third straight segment 325a extends along the second direction Y, and the third bending segment 325b extends along the thickness direction Z of the photovoltaic module, resulting in an L-shaped structure for the second body portion 325. One end of the third bending segment 325b is soldered to the first body portion 324 in the second body portion 325, and the ends of the first body portion 324 and the second body portion 325 that are far away from each other are respectively connected to the edge busbar 24.

The first body portion 324 is soldered to the second body portion 325, so that the first body portion 324 communicates with the second body portion 325. The current in the first body portion 324 can be transmitted to the second junction box through the third bending segment 325b in the second body portion 325. The second body portion 325 has an L-shaped structure, which reduces the bending number and can lower the processing difficulty of the second body portion 325. The position of the second body portion 325 can be determined based on the positions of the second busbar 22 and the third busbar 23, so that the three jumper wires of the second lead-out end are located in a same straight line, facilitating the connection between the second lead-out end and the second junction box.

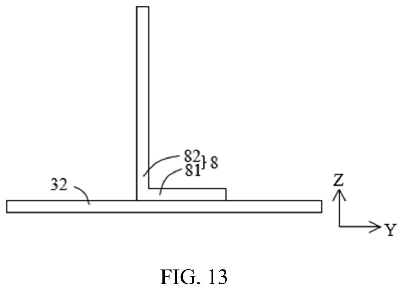

As shown in FIG. 13, in some embodiments of the present disclosure, a second lead out member 8 is provided on the second jumper wire 32. The second lead out member 8 includes a second fixing portion 81 and a second lead out portion 82. The second fixing portion 81 extends along the second direction Y and is soldered and fixed to the second jumper wire 32. The second lead out portion 82 extends along the thickness direction Z of the photovoltaic module.

The second lead out member 8 is soldered to the second jumper wire 32, so that the current inside the second jumper wire 32 can be conducted to the second junction box through the second lead out member 8. The position of the second lead out 32 in the second jumper wire 32 can be determined based on the positions of the second busbar 22 and the third busbar 23, so that the three jumper wires of the second lead-out end are in a same straight line, facilitating the connection between the second lead-out end and the second junction box.

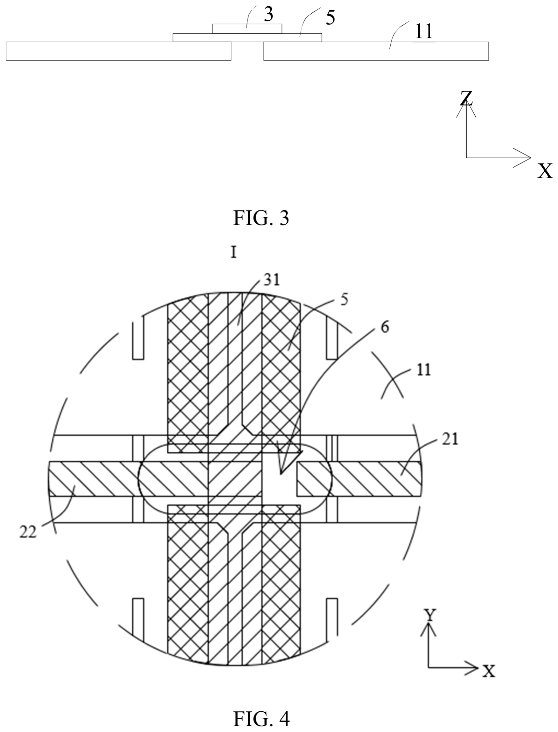

As shown in FIG. 4 and FIG. 8, the photovoltaic module includes a first lead-out hole 6 and a second lead-out hole 7. The cross-sectional area of the first lead-out hole 6 is smaller than or equal to that of the second lead-out hole 7. The first lead-out end is connected to the first junction box through the first lead-out hole 6, and the second lead-out end is connected to the second junction box through the second lead-out hole 7.

Along the second direction Y, the first busbar 21, the second busbar 22, the third busbar 23, the first lead-out hole 6, and the second lead-out hole 7 are all located between adjacent cell strings 1. The distance between the busbar and the cell string 1 is 3 mm, and the distance between the first lead-out hole 6, the second lead-out hole 7 and the cell string 1 is 1 mm to 2 mm. This can reduce the possibility of short circuit which is caused by water vapor in the environment entering the interior of the photovoltaic module through the first lead-out hole 6 or the second lead-out hole 7 and then coming into contact with the multi segmented cell 11. It can also allow the busbar to be led out through the first lead-out hole 6 or the second lead-out hole 7. The first lead-out end includes two jumper wires, one of which is the first bending portion 211 of the first busbar 21, and the other is the fifth bending portion 222 of the second busbar 22 or the first lead out portion 42 of the first lead out member 4. The second lead-out end includes three jumper wires, one of which is the second bending portion 221 of the second busbar 22, another one other is the third bending portion 231 of the third busbar 23, and another one is one of the fourth bending portion 321 or the third bending segment 325b or the second lead out portion 82 in the second jumper wire 32. The first lead-out hole 6 and the second lead-out hole 7 can be waist holes, or through holes with rectangular, elliptical or other shapes. In order to maintain the distance between the first lead-out hole 6, the second lead-out hole 7 and the multi segmented cell 11, the size of the first lead-out hole 6 and the second lead-out hole 7 is fixed along the second direction Y. The cross-sectional area of the first lead-out hole 6 is smaller than or equal to that of the second lead-out hole 7. Along the first direction X, the size of the first lead-out hole 6 can be reduced so that the jumper wires at the first end are all located within the range of the first lead-out hole 6. Along the first direction X, the size of the second lead-out hole 7 is relatively large, which can increase the spacing between multiple jumper wires at the second lead-out end, thereby reducing the possibility of short circuit caused by accidental contact of multiple jumper wires at the second lead-out end.

The present disclosure relates to a photovoltaic module, which includes cell strings 1. Each of the cell strings 1 includes multi segmented cells 11 connected in series. Two ends of one of the cell strings 1 are provided with a busbar 2 to connect the multi segmented cells 1, the busbar 2 includes a first busbar 21, a second busbar 22 and a third busbar 23. Along a first direction X, the first busbar 21, the second busbar 22 and the third busbar 23 are spaced apart. An end of the first busbar 21 opposite to the second busbar 22 is a first lead-out end, and an end of the second busbar 22 opposite to the third busbar 23 is a second lead-out end. The photovoltaic module further includes a first jumper wire 31, the first jumper wire 31 overlaps with the second busbar 22. A first bending portion 211 is provided on an end of the first busbar 21 adjacent to the second busbar 22. A side of the first jumper wire 31 away from the second busbar 22 is provided with a first lead out member 4. This facilitates adjusting a distance between the first lead out member 4 and the first bending portion 211, thereby reducing the possibility short circuit caused by accidental contact between the first lead out member 4 and the first bending portion 211, and improving the safety of the photovoltaic module.

The above are merely exemplary embodiments of the present disclosure, which, as mentioned above, are not used to limit the present disclosure. Any modification, equivalent substitution, improvement, etc., shall fall into the protection scope of the present disclosure.

## Claims

1. A photovoltaic module, comprising:
cell strings (1), wherein each of the cell strings comprises multi segmented cells (11) connected in series; two ends of one of the cell strings (1) are provided with a busbar (2) to connect the cell strings (1); the busbar (2) comprises a first busbar (21), a second busbar (22) and a third busbar (23); along a first direction, the first busbar (21), the second busbar (22) and the third busbar (23) are spaced apart, an end of the first busbar (21) opposite to the second busbar (22) is a first lead-out end, and an end of the second busbar (22) opposite to the third busbar (23) is a second lead-out end; and
a jumper wire (3) connected to the busbar (2) and extending along a second direction perpendicular to the first direction;
wherein the jumper wire (3) comprises a first jumper wire (31) and a second jumper wire (32), the first jumper wire (31) is located between the first busbar (21) and the second busbar (22) and overlaps the second busbar (22),
wherein the second jumper wire (32) is located between the second busbar (22) and the third busbar (23);
a second bending portion (221) is provided at an end of the second busbar (22) adjacent to the second jumper wire (32), and a third bending portion (231) is provided at an end of the third busbar (23) adjacent to the second jumper wire (32); and
the second jumper wire (32) comprises a fourth bending portion (321), and the second bending portion (221), the third bending portion (231), and the fourth bending portion (321) are all bent along a thickness direction of the photovoltaic module to form the second lead-out end.

2. The photovoltaic module according to claim 1, wherein a first lead out member (4) is provided on a side of the first jumper wire (31) away from the second busbar (22), and a first bending portion (211) is provided at an end of the first busbar (21) adjacent to the second busbar (22), the first lead out member (4) and the first bending portion (211) both extend along a thickness direction of the photovoltaic module to form the first lead-out end.

3. The photovoltaic module according to claim 2, wherein the first lead out member (4) comprises a first fixing portion (41) and a first lead out portion (42), an angle is formed between the first fixing portion (41) and the first lead out portion (42), the first fixing portion (41) is connected to the first jumper wire (31), and the first lead out portion (42) extends along the thickness direction of the photovoltaic module.

4. The photovoltaic module according to claim 3, wherein a width of the first fixing portion (41) is greater than or equal to a width of the first jumper wire (31).

5. The photovoltaic module according to claim 4, wherein a portion of the first fixing portion (41) protruding beyond the first jumper wire (31) is bent toward and soldered to the second busbar (22).

6. The photovoltaic module according to claim 1, wherein the second jumper wire (32) further comprises a first straight segment (322) and a second straight segment (323), the first straight segment (322) and the second straight segment (323) both extend along the second direction, and the fourth bending portion (321) is located between the first straight segment (322) and the second straight segment (323);
wherein the fourth bending portion (321) comprises a first bending segment (321a) and a second bending segment (321b), the first bending segment (321a) and the second bending segment (321b) both extend along the thickness direction of the photovoltaic module, and are connected to each other through one end of the first bending segment (321a) and one end of the second bending segment (321b), another end of the first bending segment (321a) is connected to the first straight segment (322), and another end of the second bending segment (321b) is connected to the second straight segment (323).

7. The photovoltaic module according to claim 6, wherein a gap or mutual adhesion is provided between side walls of the first bending segment (321a) and the second bending segment (321b) and the fourth bending portion (321) extends along the thickness direction of the photovoltaic module.

8. The photovoltaic module according to claim 1, wherein along the thickness direction of the photovoltaic module, the jumper wire (3) is located on one side of the multi segmented cell (11); and along the width direction of the jumper wire (3), a spacing between two adjacent segmented cells (11) is smaller than a width of the jumper wire (3), the photovoltaic module comprises an isolation member (5), along the thickness direction of the photovoltaic module, the isolation member (5) is provided between the jumper wire (3)and the multi segmented cell (11).

9. The photovoltaic module according to claim 8, wherein a notch is provided in the isolation member (5) at a position where the first jumper wire (31) overlaps the second busbar (22), to avoid the second busbar (22), and a distance between the second busbar (22) and an edge of the isolation member (5) is 1 mm to 2 mm.

10. The photovoltaic module according to claim 8, wherein the isolation member (5) located between the second jumper wire (32) and the multi segmented cell (11) is a continuous insulating strip.

11. The photovoltaic module according to claim 8, wherein the width of the jumper wire (3) ranges from 4 mm to 8 mm; and a thickness of the jumper wire (3) ranges from 0.15 mm to 0.4 mm.

12. The photovoltaic module according to claim 8, wherein a width of the isolation member (5) ranges from 8 mm to 18 mm, and
a thickness of the isolation member (5) ranges from 0.15 mm to 0.25 mm.

13. The photovoltaic module according to claim 1, further comprising a first lead-out hole (6) and a second lead-out hole (7),
wherein the first lead-out end is led out from the first lead-out hole (6), the second lead-out end is led out from the second lead-out hole (7), and a cross-sectional area of the first lead-out hole (6) is smaller than or equal to a cross-sectional area of the second lead-out hole (7).

14. The photovoltaic module according to claim 13, wherein a distance between the busbars (2) and the cell strings (1) is 3 mm; and
a distance between the first lead-out hole 6 and the second lead-out hole 7, respectively, with the cell string 1 ranges from 1 mm to 2 mm.

15. The photovoltaic module according to claim 1, wherein the multi segmented cell (11) is a four-segmented cell, and along the second direction (Y), an overlapping area width between adjacent four-segmented cells ranges from 0.2mm to 0.6mm.
